# DEMANDE DE BREVET EUROPEEN

(11) **EP 4 465 146 A1**
(43) Date de publication de la demande: **20.11.2024**
(21) Numéro de dépôt: 24174416.8
(22) Date de dépôt: 07.05.2024
(51) Int. Cl.: G05F 1/56, G05F 3/16, H03F 1/22, H03F 3/45

(54) **CIRCUIT DE GÉNÉRATION DE TENSION DE RÉFÉRENCE**

(30) Priorité: 15.05.2023 FR 2304777
(71) Demandeur: Commissariat à l'Energie Atomique et aux Energies Alternatives, 75015 Paris (FR)
(72) Inventeur: SAMIR, Anass, 38054 GRENOBLE CEDEX 09 (FR); RICAVY, Sébastien, 38054 GRENOBLE CEDEX 09 (FR); GIRAUD, Bastien, 38054 GRENOBLE CEDEX 09 (FR)
(74) Mandataire: Cabinet Beaumont

(57) **Abrégé**

La présente description concerne un dispositif (REFGEN) comprenant : un premier pont diviseur (200) entre un premier noeud (202) à une tension d'alimentation (VDDE) et un deuxième noeud (204) à un potentiel de référence (GND) ; un premier transistor (Ten) et un deuxième pont diviseur (208) en série entre les premier et deuxième noeuds, le premier transistor ayant sa grille connectée au premier pont ; un circuit tampon (BUFFa1) ayant une entrée (220) connectée à un noeud (214) du deuxième pont et une sortie (218) fournissant une tension de référence (VrefL) ; et un deuxième transistor (To1) ayant son drain connecté à la sortie du circuit tampon et sa source connectée à l'un des premier et deuxième noeuds. Le premier transistor (Ten) est bloqué si la tension d'alimentation (VDDE) est inférieure à un seuil. Le deuxième transistor est passant si le premier transistor est bloqué et inversement.

## Description

### Domaine technique

La présente description concerne de façon générale les circuits électroniques intégrés, et, plus particulièrement, un dispositif de génération de tension de référence.

### Technique antérieure

On connaît des circuits intégrés dans lesquels sont prévues une première tension d'alimentation, par exemple disponible sur un plot de connexion d'une puce comprenant ces circuits intégrés, et une deuxième tension d'alimentation, par exemple générée en interne de la puce, ayant une valeur nominale inférieure à celle de la première tension.

Parmi ces circuits électroniques connus, certains comprennent au moins un dispositif, comme par exemple une mémoire résistive, qui est alimenté par la première tension d'alimentation pour être fonctionnel. En outre, ce dispositif est mis en oeuvre avec des transistors MOS (de l'anglais "Métal Oxide Semiconductor" - métal oxyde semiconducteur) ayant une valeur limite de tenue en tension inférieure à la valeur nominale de la première tension. Pour permettre la mise en oeuvre du dispositif avec de tels transistors, des architectures cascodes (ou architectures empilées) sont utilisées.

Dans une architecture cascode, deux transistors sont en série l'un avec l'autre et l'un des deux transistors reçoit sur sa grille une tension de polarisation ou de référence.

Pour générer la tension de référence des architectures cascodes d'un tel dispositif, il a été proposé d'utiliser la deuxième tension comme tension de référence lorsque la soustraction de la valeur nominale de la deuxième tension à celle de la première tension est inférieure à la tenue en tension des transistors.

Toutefois, dans ce cas, la deuxième tension doit être appliquée aux structures cascodes avant la première tension pour ne pas détruire les transistors. En outre, lorsque les variations des première et deuxième tensions ne sont pas corrélées, cela dégrade les performances des structures cascodes, et donc du dispositif.

Pour générer la tension de référence des architectures cascodes d'un tel dispositif, il a également été proposé d'utiliser des circuits usuels de génération, à partir d'une tension d'alimentation, d'une tension continue indépendante des variations de la tension d'alimentation et de la température, et d'utiliser la tension générée comme tension de référence.

Toutefois, ces circuits usuels de génération d'une tension continue sont particulièrement sujets aux variations de procédé de fabrication.

De plus, pour obtenir une bonne stabilité en température, la tension générée ne peut prendre qu'une seule valeur qui est déterminée par le circuit utilisé pour générer cette tension. La tension générée peut alors être trop faible pour une utilisation comme tension de référence des structures cascodes. C'est par exemple le cas quand la différence entre la tension générée et la première tension d'alimentation est supérieure à la tenue en tension des transistors des structures cascodes. A l'inverse, la tension générée peut être trop élevée pour une utilisation comme tension de référence des structures cascodes. C'est par exemple le cas quand les structures cascodes doivent fonctionner lorsque la première tension est à sa valeur nominale, mais également lorsque la première tension est à une valeur plus faible correspondant, par exemple, à un mode de fonctionnement basse consommation.

Plus généralement, les solutions connues de génération d'une tension de référence pour polariser des structures cascodes présentent divers inconvénients.

### Résumé de l'invention

Il existe un besoin de pallier tout ou partie des inconvénients des solutions connues de génération d'une tension de référence, par exemple une tension de référence ou de polarisation d'une structure cascode.

Un mode de réalisation prévoir un circuit palliant tout ou partie des inconvénients des solutions connues de génération d'une tension de référence.

Un mode de réalisation prévoit un dispositif de génération de tension de référence comprenant :
un premier pont diviseur de tension connecté entre un premier noeud d'alimentation configuré pour recevoir une première tension d'alimentation et un deuxième noeud d'alimentation configuré pour recevoir un potentiel de référence ;
un premier transistor MOS et un deuxième pont diviseur de tension résistif connectés en série entre les premier et deuxième noeuds d'alimentation, le premier transistor ayant sa grille connectée à un noeud intermédiaire du premier pont et sa source connectée à l'un des premier et deuxième noeuds d'alimentation ;
un premier circuit tampon configuré pour être alimenté par la première tension et comprenant une entrée connectée à un premier noeud intermédiaire du deuxième pont et une sortie configurée pour fournir une première tension de référence ; et
un deuxième transistor MOS ayant son drain connecté à la sortie du premier circuit tampon et sa source connectée à l'un des premier et deuxième noeuds d'alimentation,
dans lequel le premier pont est configuré pour que le premier transistor soit bloqué lorsque la première tension est à une valeur inférieure à un premier seuil lui-même inférieur à une limite de tenue en tension des transistors, et
dans lequel le deuxième transistor est configuré pour être à l'état passant si le premier transistor est à l'état bloqué et inversement.

Selon un mode de réalisation :
le premier transistor est à canal N et a sa source connectée au deuxième noeud d'alimentation ;
le dispositif comprend en outre un troisième transistor MOS en série avec un premier élément résistif entre les premier et deuxième noeuds d'alimentation, le troisième transistor étant à canal P et ayant sa source connectée au premier noeud d'alimentation et sa grille connectée à un deuxième noeud intermédiaire du deuxième pont ; et
le deuxième transistor est à canal P et a sa grille connectée au drain du troisième transistor.

Selon un mode de réalisation, le dispositif comprend en outre :
un deuxième circuit tampon configuré pour être alimenté par une deuxième tension d'alimentation ayant une valeur nominale plus faible que celle de la premier tension d'alimentation ; et
un transistor MOS à canal N ayant sa source connectée au deuxième noeud d'alimentation, son drain connecté au noeud intermédiaire du premier pont et sa grille connectée à la sortie du deuxième circuit tampon,
dans lequel le deuxième circuit tampon est destiné à recevoir un signal binaire à un niveau bas correspondant à une tension nulle si une valeur courante de la première tension est supérieure à la limite de tenue en tension des transistors, et à un niveau bas ou haut déterminé par une commande sinon, le niveau haut dudit signal correspondant à la deuxième tension d'alimentation.

Selon un mode de réalisation :
le premier transistor est à canal P et a sa source connectée au premier noeud d'alimentation ;
le dispositif comprend en outre un troisième transistor MOS en série avec un premier élément résistif entre les premier et deuxième noeuds d'alimentation, le troisième transistor étant à canal N et ayant sa source connectée au deuxième noeud d'alimentation et sa grille connectée à un deuxième noeud intermédiaire du deuxième pont ; et
le deuxième transistor est à canal N et a sa grille connectée au drain du troisième transistor.

Selon un mode de réalisation, le dispositif comprend en outre :
un deuxième circuit tampon configuré pour être alimenté par une deuxième tension d'alimentation ayant une valeur nominale plus faible que celle de la premier tension d'alimentation ;
un troisième pont diviseur de tension et un transistor MOS à canal N connectés en série entre les premier et deuxième noeuds d'alimentation, le transistor sa source connectée au deuxième noeud d'alimentation, son drain connecté au troisième pont et sa grille connectée à la sortie du deuxième circuit tampon ; et
un transistor MOS à canal P ayant sa source connectée au premier noeud d'alimentation, sa grille connectée au noeud intermédiaire du troisième pont et son drain connecté au noeud intermédiaire du premier pont,
dans lequel le deuxième circuit tampon est destiné recevoir un signal binaire à un niveau bas correspondant à une tension nulle si une valeur courante de la première tension est supérieure à la limite de tenue en tension des transistors, et à un niveau bas ou haut déterminé par une commande sinon, le niveau haut dudit signal correspondant à la deuxième tension d'alimentation.

Selon un mode de réalisation, le dispositif comprend en outre :
un troisième transistor MOS et un troisième pont diviseur de tension résistif connectés en série entre les premier et deuxième noeuds d'alimentation, les sources des premier et troisième transistors étant connectées à des noeuds respectifs différents parmi les premier et deuxième noeuds d'alimentation ;
un deuxième circuit tampon configuré pour être alimenté par la première tension et comprenant une entrée connectée à un premier noeud intermédiaire du troisième pont et une sortie configurée pour fournir une deuxième tension de référence ; et
un quatrième transistor MOS ayant son drain connectée à la sortie du deuxième circuit tampon, les sources des deuxième et quatrième transistors étant connectées à des noeuds respectifs différents parmi les premier et deuxième noeuds d'alimentation ;
dans lequel le troisième transistor est configuré pour être à l'état bloqué, respectivement passant, quand le premier transistor est à l'état bloqué, respectivement passant, et dans lequel le quatrième transistor est configuré pour être à l'état passant si le troisième transistor est à l'état bloqué et inversement.

Selon un mode de réalisation :
le premier transistor est à canal N et a sa source connectée au deuxième noeud d'alimentation ;
le troisième transistor est à canal P et a sa grille connectée à un deuxième noeud intermédiaire du deuxième pont ;
le deuxième transistor est à canal P et a sa grille couplée, de préférence connectée, au drain du troisième transistor et sa source connectée au premier noeud d'alimentation ; et
le quatrième transistor est à canal N et a sa grille couplée, de préférence connectée, au drain du premier transistor.

Selon un mode de réalisation, le dispositif comprend en outre :
un troisième circuit tampon configuré pour être alimenté par une deuxième tension d'alimentation ayant une valeur nominale plus faible que celle de la première tension d'alimentation ; et
un transistor MOS à canal N ayant sa source connectée au deuxième noeud d'alimentation, son drain connecté au noeud intermédiaire du premier pont et sa grille connectée à la sortie du troisième circuit tampon,
dans lequel le troisième circuit tampon est destiné à recevoir un signal binaire à un niveau bas correspondant à une tension nulle si une valeur courante de la première tension est supérieure à la limite de tenue en tension des transistors, et à un niveau bas ou haut déterminé par une commande sinon, le niveau haut dudit signal correspondant à la deuxième tension d'alimentation.

Selon un mode de réalisation :
le premier transistor est à canal P et a sa source connectée au premier noeud d'alimentation ;
le troisième transistor est à canal N et a sa grille connectée à un deuxième noeud intermédiaire du deuxième pont ;
le deuxième transistor est à canal N et a sa grille couplée, de préférence connectée, au drain du troisième transistor et sa source connectée au deuxième noeud d'alimentation ; et le quatrième transistor est à canal P et a sa grille couplée, de préférence connectée, au drain du premier transistor.

Selon un mode de réalisation, le dispositif comprend en outre :
un troisième circuit tampon configuré pour être alimenté par une deuxième tension d'alimentation ayant une valeur nominale plus faible que celle de la premier tension d'alimentation ;
un quatrième pont diviseur de tension et un transistor MOS à canal N connectés en série entre les premier et deuxième noeuds d'alimentation, le transistor ayant sa source connectée au deuxième noeud d'alimentation, son drain connecté au quatrième pont et sa grille connectée à la sortie du troisième circuit tampon ; et
un transistor MOS à canal P ayant sa source connectée au premier noeud d'alimentation, sa grille connectée au noeud intermédiaire du quatrième pont et son drain connecté au noeud intermédiaire du premier pont,
dans lequel le troisième circuit tampon est configuré pour recevoir un signal binaire à un niveau bas correspondant à une tension nulle si une valeur courante de la première tension est supérieure à la limite de tenue en tension des transistors, et à un niveau bas ou haut déterminé par une commande sinon, le niveau haut dudit signal correspondant à la deuxième tension d'alimentation.

Un mode de réalisation prévoit un système comprenant un dispositif tel que décrit ci-dessus, et un circuit configuré pour recevoir ladite commande, la première tension et la deuxième tension, et pour fournir ledit signal binaire.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de manière schématique et sous la forme de blocs, un exemple d'un système électronique comprenant un circuit de génération de tension de référence selon un mode de réalisation ;
la figure 2 illustre, sous la forme d'un circuit, un mode de réalisation du circuit de génération de la figure 1 ;
la figure 3 illustre, sous la forme d'un circuit, un autre de réalisation du circuit de génération de la figure 1 ;
la figure 4 représente, sous la forme d'un circuit, une variante de réalisation du circuit de la figure 2 ;
la figure 5 représente, sous la forme d'un circuit, une variante de réalisation du circuit de la figure 3 ;
la figure 6 représente, sous la forme d'un circuit, un exemple de mode de réalisation d'un circuit tampon analogique ; et
la figure 7 représente, sous la forme d'un circuit, un exemple d'un autre mode de réalisation d'un circuit tampon analogique.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

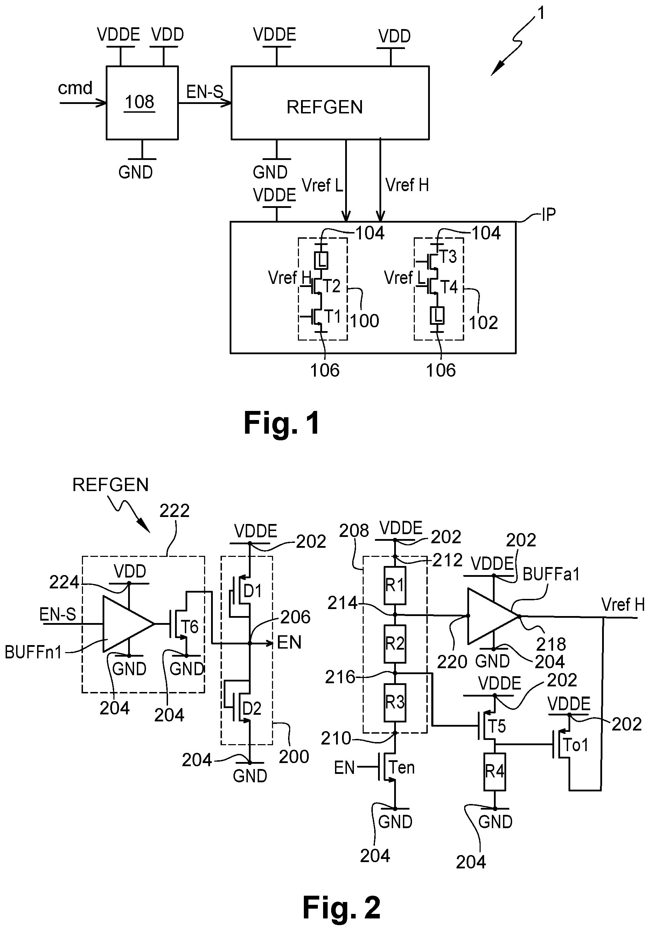

La figure 1 représente, de manière schématique et sous la forme de blocs, un exemple d'un système électronique 1 comprenant un dispositif REFGEN de génération de tension de référence selon un mode de réalisation.

Plus particulièrement, le système 1, correspondant par exemple à une portion d'une puce de circuit intégré, comprend un dispositif IP, par exemple une mémoire résistive, et le dispositif REFGEN.

Le dispositif IP est alimenté par une tension d'alimentation VDDE, par exemple disponible sur un plot de connexion de la puce. A titre d'exemple, la tension VDDE a une valeur nominale sensiblement égale 3,3 V. Le dispositif IP comprend une borne configurée pour recevoir la tension VDDE, et une autre borne configurée pour recevoir un potentiel de référence GND, par exemple la masse, auquel est référencée la tension VDDE.

Le dispositif IP comprend des structures cascodes à transistors MOS. Par exemple, le dispositif IP comprend des structures cascodes 100 à transistors MOS à canal N et des structures cascodes 102 à transistors MOS à canal P.

A titre d'exemple, chaque structure 100 comprend deux transistors MOS T1 et T2 à canal N connectés en série entre un noeud 104 recevant la tension VDDE et un noeud 106 recevant le potentiel GND. Le transistor T1 a sa source connectée au noeud 106 et son drain connecté à la source du transistor T2, la source du transistor T2 étant couplée au noeud 104 par une charge L. La grille du transistor T2 est configurée pour recevoir une tension de référence ou de polarisation VrefH. Le transistor T2 est, par exemple, appelé transistor cascode. La grille du transistor T1 est configurée pour recevoir une tension de commande comprise entre 0 V et la tension de polarisation VrefH.

De manière symétrique, à titre d'exemple, chaque structure 102 comprend deux transistors MOS T3 et T4 à canal P connectés en série entre les noeuds 104 et 106. Le transistor T2 a sa source connectée au noeud 104 et son drain connecté à la source du transistor T2, la source du transistor T2 étant couplée au noeud 106 par une charge L. La grille du transistor T4 est configurée pour recevoir une tension de référence ou de polarisation VrefL. Le transistor T4 est, par exemple, appelé transistor cascode. La grille du transistor T3 est configurée pour recevoir une tension de commande comprise entre la tension de référence VrefL et la tension d'alimentation VDDE.

Dans la suite de la description, on appelle Vmax la tension maximale qui peut être appliquée entre la grille et la source ou entre la source et le drain de chacun des transistors du dispositif IP sans que cela n'endommage le transistor. Dit autrement, Vmax est la limite de tenue en tension des transistors MOS du dispositif IP.

De préférence, les tensions VrefL et VrefH ont des valeurs différentes. Par exemple, pour optimiser le fonctionnement des transistors à canal N et à canal P du dispositif IP, la tension VrefL est choisie égale à tension VDEE moins la tension VrefH. Toutefois, dans d'autres exemples, les tensions VrefL et VrefH ont la même valeur.

Les tensions VrefH et VrefL sont reçues par le dispositif IP.

Le dispositif REFGEN est configuré pour fournir les tensions VrefL et VrefH. Le dispositif REFGEN est alimenté par la tension VDDE. Le dispositif REFGEN a, par exemple, une borne recevant la tension VDDE, et une autre borne recevant le potentiel de référence GND.

Selon un mode de réalisation, le dispositif REFGEN est en outre configuré pour recevoir une tension d'alimentation VDD et un signal binaire EN-S.

La tension VDD a une valeur nominale plus faible que celle de la tension VDDE. En particulier, la tension VDD est inférieure à la limite de tenue en tension Vmax. Par exemple, le résultat de la soustraction de la valeur nominale de la tension VDD à celle de la tension VDDE est inférieure à la limite de tenue en tension des transistors T1, T2, T3 et T4 du dispositif IP. A titre d'exemple, la tension VDD est une tension générée par un circuit (non représenté) de la puce de circuit intégré comprenant le système 1.

Le signal EN-S est un signal binaire dont le niveau bas correspond à une tension nulle, et dont le niveau haut correspond à la tension VDD. Le signal EN-S est configuré pour être par défaut à son niveau bas. Le signal EN-S est en outre configuré pour être à son niveau bas lorsque la valeur courante de la tension VDDE est supérieure à la tension Vmax. Lorsque la valeur courante de la tension VDDE est inférieure à la tension Vmax, le niveau du signal EN-S est déterminé par un signal de commande cmd. Par exemple, la mise au niveau du signal EN-S avec le signal cmd lorsque la tension VDDE est inférieure à la tension Vmax correspond à un mode de fonctionnement basse consommation où la tension VDDE est à une valeur courante plus faible que sa valeur nominale, par exemple une valeur courante égale à la valeur nominale de la tension VDD.

A titre d'exemple, le système 1 comprend un circuit 108 configuré pour recevoir les tensions VDDE et VDD, le potentiel GND et le signal cmd, et pour fournir le signal EN-S. La mise en oeuvre d'un tel circuit 108, et, plus généralement la génération du signal EN-S, sont à la portée de la personne de métier, par exemple en utilisant des circuits usuels de réinitialisation à l'allumage (PoR de l'anglais "Power-on Reset").

Dans une variante de réalisation, le circuit REFGEN ne reçoit pas le signal EN-S et la tension VDD.

Dans l'exemple de la figure 1, le dispositif IP comprend des structures 100 et 102, et le dispositif REFGEN fournit donc les deux tensions VrefH et VrefL. Dans d'autres exemples, le dispositif IP ne comprend pas de structure 100 et le dispositif REFGEN ne fournit alors que la tension VrefL, ou, à l'inverse, le dispositif IP ne comprend pas de structure 102 et le dispositif REFGEN ne fournit alors que la tension VrefH.

La figure 2 illustre, sous la forme d'un circuit, un mode de réalisation du circuit REFGEN de la figure 1. Dans ce mode de réalisation, le dispositif REFGEN est configuré pour ne fournir que la tension VrefH.

Le dispositif REFGEN comprend un pont diviseur de tension 200. Le pont 200 est connecté entre un noeud 202 configuré pour recevoir la tension VDDE, et un noeud 204 configuré pour recevoir le potentiel GND. Par exemple, le pont 200 a une extrémité connectée au noeud 202 et une extrémité connectée au noeud 204.

Selon un mode de réalisation, le pont 200 comprend un ou plusieurs transistors MOS à canal P connectés en série entre le noeud 202 et un noeud 206 intermédiaire du pont 200. Chacun de ces transistors à canal P est monté en diode, ou, dit autrement, a son drain connecté à sa grille. Chacun de ces transistors à canal P a sa source du côté du noeud 202. En figure 2, ces transistors à canal P sont représentés sous la forme d'un seul transistor MOS à canal P, D1. De manière symétrique, le pont 200 comprend un ou plusieurs transistors MOS à canal N connectés en série entre le noeud 206 et le noeud 204. Chacun de ces transistors à canal N est monté en diode, ou, dit autrement, a son drain connecté à sa grille. Chacun de ces transistors à canal N a sa source du côté du noeud 204. En figure 2, ces transistors à canal N sont représentés sous la forme d'un seul transistor MOS à canal N, D2.

Selon une variante de réalisation, les transistors MOS à canal P du pont 200 sont remplacés par des diodes, par exemple des diodes ayant leurs anodes du côté du noeud 202, et les transistors MOS à canal N du pont 200 sont aussi remplacés par des diodes, par exemple des diodes ayant leurs anodes du côté du noeud 206.

Selon une autre variante de réalisation, les transistors à canal P du pont 200 sont remplacés par un élément résistif comprenant une ou plusieurs résistances en série entre les noeuds 202 et 206, et les transistors à canal N du pont 200 sont remplacés par un autre élément résistif comprenant une ou plusieurs résistances en série entre les noeud 206 et 204.

Le dispositif REFGEN comprend un transistor MOS Ten et un pont diviseur de tension résistif 208, le transistor Ten et le pont 208 étant connectés en série entre les noeuds 202 et 204.

Le transistor Ten a sa grille connectée au noeud 206 sur lequel est disponible une tension EN. La source du transistor Ten est connectée au noeud 204 dans le mode de réalisation de la figure 2. Dans le mode de réalisation de la figure 2, le transistor Ten est à canal N.

Le pont diviseur 208 a une extrémité 210 connectée au drain du transistor Ten. Le pont diviseur 208 a une autre extrémité 212 connectée au noeud 202 dans le mode de réalisation de la figure 2.

Le pont 208 comprend, par exemple, au moins trois éléments résistifs R1, R2 et R3. Chaque élément résistif R1, R2, R3 du pont 208 peut correspondre à une unique résistance ou à une association en série et/ou parallèle de plusieurs résistances. A titre d'exemple, l'élément R1 est connecté entre l'extrémité 212 et un noeud intermédiaire 214 du pont 208, l'élément R2 est connecté entre le noeud 214 et un autre noeud intermédiaire 216 du pont 208, et l'élément R3 est connecté entre le noeud 216 et l'extrémité 210 du pont.

Le dispositif REFGEN comprend un circuit tampon BUFFa1. Le circuit BUFFa1 est alimenté par la tension VDDE. Par exemple, le circuit BUFFa1 a une borne connectée au noeud 202 et une borne connectée au noeud 204.

Le circuit BUFFa1 est un circuit tampon analogique. Dit autrement, le circuit BUFFa1 est configuré pour fournir sur sa sortie 218 une tension ayant une valeur identique à celle d'une tension qu'il reçoit sur son entrée 220, tout en assurant une isolation entre son entrée et sa sortie. Dit encore autrement, le circuit BUFFa1 est un circuit suiveur à gain unitaire.

L'entrée 218 du circuit BUFFa1 est connectée à un noeud intermédiaire du pont 208, par exemple au noeud 214. La sortie 220 du circuit BUFFa1 fournit la tension VrefH.

Le dispositif REFGEN comprend en outre un transistor MOS To1. Le drain du transistor To1 est connecté à la sortie du circuit BUFFa1. La source du transistor To1 est connectée au noeud 202 dans le mode de réalisation de la figure 2 où le dispositif REFGEN est configuré pour fournir la tension VrefH. Dans le mode de réalisation de la figure 2, le transistor To1 est à canal P.

Le transistor To1 est configuré pour être à l'état passant lorsque le transistor Ten est à l'état bloqué, et pour être à l'état bloqué lorsque le transistor Ten est à l'état passant. Plus particulièrement, le transistor To1 est configuré pour que son état passant ou bloqué soit déterminé par une valeur de tension sur un noeud intermédiaire du pont diviseur 208, par exemple sur le noeud 216 du pont 208.

Dans l'exemple de la figure 2, le dispositif REFGEN comprend un transistor MOS à canal P T5 et un élément résistif R4 en série entre les noeud 202 et 204. Le transistor T5 a sa grille connectée au noeud 216 du pont 208, sa source connectée au même noeud 202 que la source du transistor To1, et son drain couplé au noeud 204 par l'élément R4. La grille du transistor To1 est connectée au drain du transistor T5.

Dans le circuit REFGEN, le pont diviseur 200 est configuré pour que le transistor Ten soit à l'état bloqué si la tension VDDE est inférieure à un seuil VT1, par exemple sensiblement égal à 0,9 V. De préférence, le seuil VT1 est inférieur la tension Vmax. A l'inverse, le pont diviseur 200 est configuré pour que le transistor Ten soit passant si la tension VDDE est supérieure au seuil VT1. Plus particulièrement, le pont diviseur 200 est configuré pour avoir le fonctionnement ci-dessus lorsqu'il est pris seul, c'est-à-dire lorsqu'aucun circuit ne vient modifier directement le potentiel du noeud 206, par exemple en tirant ce noeud 206 à GND ou VDDE.

Ainsi, lorsque le pont 200 est pris seul et que la tension VDDE est inférieure au seuil VT1, la tension EN est inférieure au seuil du transistor Ten qui est alors à l'état bloqué. Il en résulte que le noeud 216 est à la tension VDDE, et donc que le transistor T5 est à l'état bloqué. L'état bloqué du transistor T5 entraîne que la grille du transistor To1 reçoit le potentiel GND et donc que le transistor To1 est à l'état passant. La sortie 218, donc la tension VrefH, est alors tirée à la tension VDDE. Dit autrement, tant que la tension VDDE est inférieure au seuil VT1, la tension VrefH suit la tension VDDE. A l'inverse, lorsque le pont 200 est pris seul et que la tension VDDE est supérieure ou égale au seuil VT1, la tension EN est suffisante pour que le transistor Ten soit passant, d'où il résulte que le transistor T5 devient passant, cet état passant du transistor T5 forçant le transistor To1 à l'état bloqué. La tension VrefH est alors égale à la tension sur l'entrée 220 du circuit BUFFa1. A titre d'exemple, le pont diviseur 208 est configurée pour que, lorsque le transistor Ten est passant, la tension sur l'entrée 220 du circuit BUFFa1 soit égale à 0,55 fois la tension VDDE lorsque la sortie 218 du circuit BUFFa1 fournit la tension VrefH.

Dans un mode de réalisation (non illustré), le circuit REFGEN ne reçoit pas le signal EN-S et la tension VDD.

Dans un autre mode de réalisation, comme cela est illustré par la figure 2, le dispositif REFGEN reçoit le signal EN-S et la tension VDD. Le dispositif REFGEN comprend alors un circuit 222 configuré pour recevoir le signal EN-S et pour tirer, uniquement lorsque le signal EN-S est à son niveau haut, le noeud 206 à celui du potentiel GND et de la tension VDDE qui met le transistor Ten à l'état bloqué lorsqu'il est appliqué sur la grille du transistor. Dans le mode de réalisation de la figure 2 où le transistor Ten est à canal N et a sa source connectée au noeud 204, le circuit 222 est configuré pour tirer le noeud 206 au noeud 204 lorsque le signal EN-S est à son niveau haut.

Lorsque la tension VDDE est inférieure à Vmax et que le signal cmd commande le niveau haut du signal EN-S, la prévision du circuit 222 permet que la tension VrefH soit égale à la tension du noeud 202 auquel est connectée la source du transistor To1. A titre d'exemple, un tel fonctionnement permet que, dans un mode basse alimentation où la tension VDDE est à une valeur faible par rapport à sa valeur nominale et inférieure à la tension Vmax, par exemple une valeur faible égale à la valeur nominale de la tension VDD, la tension VrefH soit à une valeur permettant le fonctionnement des structures cascodes 100 du dispositif IP (figure 1).

Dans le mode de réalisation de la figure 2, le circuit 222 comprend un circuit tampon BUFFn1 et un transistor MOS à canal N T6. Le circuit BUFFn1 est alimentée par la tension VDD. Par exemple, le circuit BUFFn1 a une borne connectée au noeud 204 et une borne connectée à un noeud 224 configuré pour recevoir la tension VDD.

Le circuit BUFFn1 est un circuit tampon numérique. Le circuit BUFFn1 est donc configuré pour fournir sur sa sortie 226 un signal numérique au niveau haut (VDD) lorsque son entrée 228 reçoit le niveau haut du signal EN-S, et au niveau bas (GND) lorsque son entrée reçoit le niveau bas (GND) du signal EN-S, tout en assurant une isolation entre son entrée et sa sortie. A titre d'exemple, le circuit BUFFn1 comprend deux inverseurs en série entre son entrée 228 et sa sortie 226.

Le transistor T6 a sa source connectée au noeud 204, sa grille connectée à la sortie 226 du circuit BUFFn1 et son drain connecté au noeud 206 du pont 200.

On a décrit ci-dessus en relation avec la figure 2, un mode de réalisation où le dispositif REFGEN est configuré pour fournir la tension VrefH, ce qui implique que le transistor To1 a sa source connectée au noeud 202.

Dans une variante de réalisation (non illustrée), le dispositif décrit en relation avec la figure 2 est configuré pour générer la tension VrefL. Dans ce cas, le transistor To1 est à canal N, et a sa source connectée au noeud 204. Dans une telle variante, le transistor To1 reste commandé à partir d'une tension sur un noeud intermédiaire du pont 208, par exemple sur le noeud 216, de sorte à être passant lorsque le transistor Ten est bloqué, et à être bloqué lorsque le transistor Ten est passant. Dans une telle variante, la grille du transistor To1 est, par exemple, connectée au noeud 216, le transistor T5 et l'élément résistif R4 pouvant être omis. Dans une telle variante, la tension VrefL est alors fournie sur la sortie du circuit BUFFa1 à la place de la tension VrefH, la tension VrefL étant nulle tant que le transistor Ten est bloqué et égale à la tension sur le noeud 214 lorsque le transistor Ten est passant. A titre d'exemple, quand la sortie 218 du circuit BUFFa1 fournit la tension VrefL, le pont 208 est configuré pour que la tension sur le noeud 214 soit égale à 0,45 fois la tension VDDE lorsque le transistor Ten est passant.

Le dispositif REFGEN décrit en relation avec la figure 2 présente l'avantage de pouvoir être mis en oeuvre avec des transistors MOS similaires à ceux du dispositif IP, c'est à dire des transistors MOS ayant une tenue en tension Vmax.

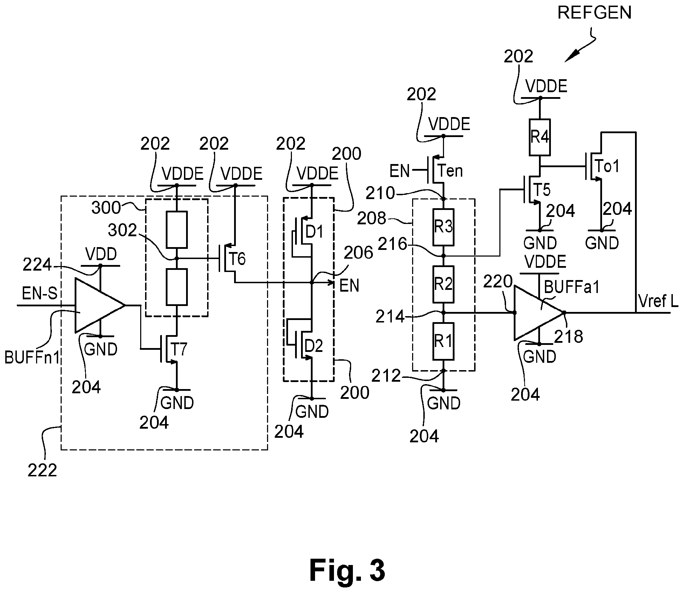

La figure 3 illustre, sous la forme d'un circuit, un autre de réalisation du circuit REFGEN de la figure 1. Dans ce mode de réalisation, le dispositif REFGEN est configuré pour ne fournir que la tension VrefL.

Le dispositif REFGEN de la figure 3 comprend de nombreux éléments en commun avec celui de la figure 2, et seules les différences entre ces deux dispositifs sont ici mises en exergue. En particulier, sauf indication contraire, tous ce qui a été indiqué pour le dispositif REFGEN décrit en relation avec la figure 2 s'applique au dispositif REFGEN de la figure 3.

Le dispositif REFGEN comprend le pont diviseur de tension 200, le pont diviseur de tension résistif 208, le circuit tampon BUFFa1, le transistor Ten et le transistor To1.

Le transistor Ten et le pont 208 sont connectés en série entre les noeuds 202 et 204. Toutefois, à la différence de ce qui a été décrit en relation avec la figure 2, en figure 3, le transistor Ten est à canal P et a sa source connectée au noeud 202, l'extrémité 212 du pont diviseur 208 étant donc connectée au noeud 204.

En outre, dans le mode de réalisation de la figure 3, la sortie 218 du circuit tampon BUFFa1 fournit la tension VrefL et non pas la tension VrefH comme en figure 2. L'entrée 218 du circuit BUFFa1 est connectée à un noeud intermédiaire du pont 208, par exemple au noeud 214.

Dans le mode de réalisation de la figure 3 où le dispositif REFGEN est configuré pour fournir la tension VrefL, la source du transistor To1 est connectée au noeud 204 et le transistor To1 est à canal N. Comme en figure 2, dans le dispositif REFGEN de la figure 3, le transistor To1 est configuré pour être à l'état passant lorsque le transistor Ten est à l'état bloqué, et pour être à l'état bloqué lorsque le transistor Ten est à l'état passant. Plus particulièrement, le transistor To1 est configuré pour que son état passant ou bloqué soit déterminé par une valeur de tension sur un noeud intermédiaire du pont diviseur 208, par exemple sur le noeud 216 du pont 208.

Dans l'exemple de la figure 3, le dispositif REFGEN comprend le transistor MOS T5 et l'élément résistif R4 en série entre les noeud 202 et 204. Toutefois, par rapport à ce qui a été décrit en relation avec la figure 2, en figure 3 le transistor T5 est à canal N et a sa source connectée au noeud 204.

Comme en figure 2, en figure 3 le pont diviseur 200 est configuré pour que le transistor Ten soit à l'état bloqué si la tension VDDE est inférieure à un seuil VT1, par exemple sensiblement égal à 0,9 V, et pour que le transistor Ten soit passant si la tension VDDE est supérieure au seuil VT1. Plus particulièrement, le pont diviseur 200 est configuré pour avoir le fonctionnement ci-dessus lorsqu'il est pris seul.

Ainsi, lorsque le pont 200 est pris seul et que la tension VDDE est inférieure au seuil VT1, l'écart entre les tensions EN et VDDE n'est pas suffisant pour que le transistor Ten soit passant. L'état bloqué du transistor Ten implique que le noeud 216 est au potentiel GND d'où il résulte que le transistor T5 est à l'état bloqué et que la grille du transistor To1 reçoit la tension VDDE. Le transistor To1 est alors à l'état passant et la tension VrefL est nulle. A l'inverse, lorsque le pont 200 est pris seul et que la tension VDDE est supérieure ou égale au seuil VT1, l'écart entre les tensions EN et VDDE est suffisant pour que le transistor Ten soit passant, d'où il résulte que le transistor T5 devient passant ce qui met le transistor To1 à l'état bloqué. La tension VrefL est alors égale à la tension sur l'entrée 220 du circuit BUFFa1. A titre d'exemple, quand la sortie 218 du circuit BUFFa1 fournit la tension VrefL, le pont 208 est configuré pour que la tension sur le noeud 214 soit égale à 0,45 fois la tension VDDE lorsque le transistor Ten est passant.

Dans un mode de réalisation (non illustré), le circuit REFGEN ne reçoit pas le signal EN-S et la tension VDD.

Dans un autre mode de réalisation, comme cela est illustré par la figure 3, le dispositif REFGEN reçoit le signal EN-S et la tension VDD. Le dispositif REFGEN comprend alors le circuit 222 configuré pour recevoir le signal EN-S et pour tirer, lorsque le signal EN-S est à son niveau haut, le noeud 206 à celui du potentiel GND et de la tension VDDE qui commande l'état bloqué du transistor Ten. Ainsi, dans le mode de réalisation de la figure 3 où le transistor Ten est à canal P et a sa source connectée au noeud 202, le circuit 222 est configuré pour tirer le noeud 206 au noeud 202 lorsque le signal EN-S est à son niveau haut.

Lorsque la valeur courante de la tension VDDE est inférieure à Vmax et que le signal cmd commande le niveau haut du signal EN-S, la prévision du circuit 222 permet que la tension VrefL soit égale à la tension du noeud 204 auquel est connectée la source du transistor To1. A titre d'exemple, un tel fonctionnement permet que, dans un mode basse alimentation où la tension VDDE est à une valeur faible par rapport à sa valeur nominale et inférieure à la tension Vmax, la tension VrefL soit à une valeur permettant le fonctionnement des structures cascodes 102 du dispositif IP (figure 1).

Dans le mode de réalisation de la figure 3, le circuit 222 comprend le circuit tampon BUFFn1 et le transistor MOS T6. Toutefois, dans cet exemple, le transistor T6 est à canal P et a sa source connectée au noeud 202, et sa grille n'est pas connectée à la sortie du circuit BUFFn1. Le circuit 222 comprend alors en outre un transistor MOS à canal N T7 et un pont diviseur de tension 300 connecté en série entre les noeuds 202 et 204. Le pont 300, de préférence un pont diviseur résistif, est connecté entre le noeud 202 et le transistor T7. Le transistor T7 a sa source connectée au noeud 204, sa grille connectée à la sortie du circuit BUFFn1 et son drain connecté au pont 300. La grille du transistor T6 est connectée à un noeud intermédiaire 302 du pont 300.

Dans la mise en oeuvre décrite ici du circuit 222, lorsque la tension VDDE est supérieure à la tension Vmax et que le signal EN-S est donc à son niveau bas, le transistor T7 a alors une tension grille-source nulle mais une tension drain-source égale à la VDDE et donc supérieure à la tenue en tension Vmax des transistors du dispositif IP. Ainsi, le transistor T7 est choisit pour pouvoir tenir la tension VDDE sur son drain. Par exemple, le transistor T7 est un transistor à drain étendu.

Le dispositif REFGEN décrit en relation avec la figure 3 présente l'avantage de pouvoir être mis en oeuvre avec des transistors MOS similaires à ceux du dispositif IP, c'est à dire des transistors MOS ayant une tenue en tension Vmax, sauf en ce qui concerne le transistor T7 qui est dimensionner pour pouvoir tenir la tension VDDE sur son drain.

On a décrit ci-dessus en relation avec la figure 3, un mode de réalisation où le dispositif REFGEN est configuré pour fournir la tension VrefL, ce qui implique que le transistor To1 a sa source connectée au noeud 204.

Dans une variante de réalisation, le dispositif décrit en relation avec la figure 3 est configuré pour générer la tension VrefH. Dans ce cas, le transistor To1 est à canal P, et a sa source connectée au noeud 202. Dans une telle variante, le transistor To1 reste commandé à partir d'une tension sur un noeud intermédiaire du pont 208, par exemple le noeud 216, de sorte à être passant lorsque le transistor Ten est bloqué, et à être bloqué lorsque le transistor Ten est passant. Dans une telle variante, la grille du transistor To1 est, par exemple, connectée au noeud 216, le transistor T5 et l'élément résistif R4 pouvant être omis. Dans une telle variante, la tension VrefH est alors fournie sur la sortie du circuit BUFFa1 à la place de la tension VrefL, la tension VrefH suivant la tension VDDE tant que le transistor Ten est bloqué et étant égale à la tension sur le noeud 214 lorsque le transistor Ten est passant. A titre d'exemple, quand la sortie 218 du circuit BUFFa1 fournit la tension VrefH, le pont 208 est configuré pour que la tension sur le noeud 214 soit égale à 0,55 fois la tension VDDE lorsque le transistor Ten est passant.

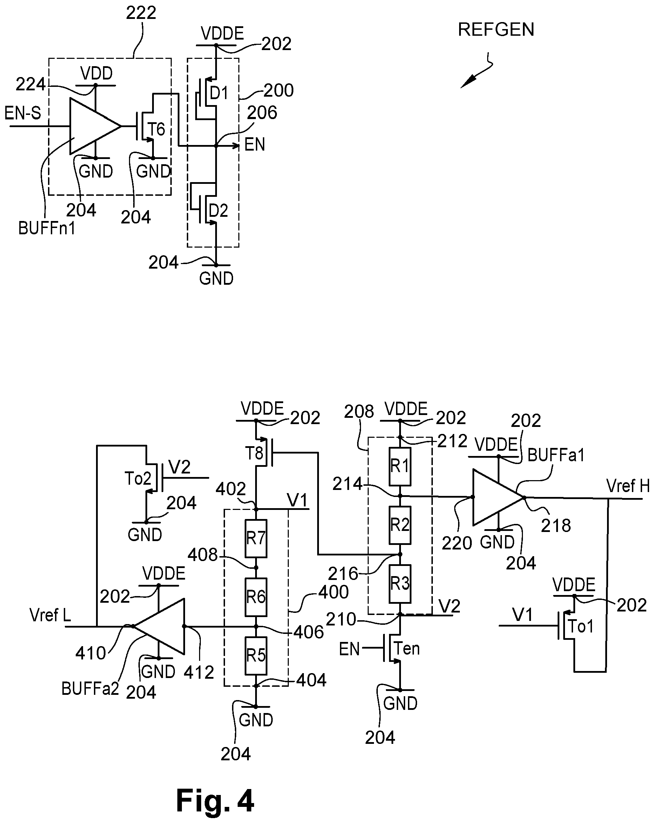

La figure 4 représente, sous la forme d'un circuit, une variante de réalisation du circuit REFGEN de la figure 2. Par rapport au circuit REFGEN de la figure 2 qui est configuré pour fournir la tension VrefH, le circuit REFGEN de la figure 4 est configuré pour générer la tension VrefH et la tension VrefL.

Le dispositif REFGEN de la figure 4 comprend de nombreux éléments en commun avec celui de la figure 2, et seules les différences entre ces deux dispositifs sont ici mises en exergue. En particulier, sauf indication contraire, tous ce qui a été indiqué pour le dispositif REFGEN décrit en relation avec la figure 2 s'applique au dispositif REFGEN de la figure 4.

Par rapport au dispositif REFGEN de la figure 2, le dispositif REFGEN de la figure 4 comprend en outre un pont diviseur de tension résistif 400 et un transistor MOS T8 en série entre les noeuds 202 et 204.

La source du transistor T8 est connectée à celui des noeuds 202 et 204 auquel n'est pas connectée la source du transistor Ten, c'est-à-dire au noeud 202 dans le mode de réalisation de la figure 4. Dans le mode de réalisation de la figure 4, le transistor T8 est à canal P.

Le transistor T8 est configuré pour être passant, respectivement bloqué, lorsque le transistor Ten est passant, respectivement bloqué. Dans le mode de réalisation de la figure 4, Le transistor T8 a sa grille connectée à un noeud intermédiaire du pont 208, par exemple au noeud 216.

Le pont diviseur 400 a une extrémité 402 connectée au drain du transistor T8. Le pont diviseur 400 a une autre extrémité 404 connectée au noeud 204 dans le mode de réalisation de la figure 4.

Le pont 400 comprend, par exemple, au moins trois éléments résistifs R5, R6 et R7. Chaque élément résistif R5, R6, R7 du pont 400 peut correspondre à une unique résistance ou à une association en série et/ou parallèle de plusieurs résistances. A titre d'exemple, l'élément R5 est connecté entre l'extrémité 404 et un noeud intermédiaire 406 du pont 400, l'élément R6 est connecté entre le noeud 406 et un autre noeud intermédiaire 408 du pont 400, et l'élément R7 est connecté entre le noeud 408 et l'extrémité 402 du pont 400.

Par rapport au dispositif REFGEN de la figure 2, le dispositif REFGEN de la figure 4 comprend un circuit tampon BUFFa2. Le circuit BUFFa2 est alimenté par la tension VDDE. Par exemple, le circuit BUFFa2 a une borne connectée au noeud 202 et une borne connectée au noeud 204.

Le circuit BUFFa2 est un circuit tampon analogique. Dit autrement, le circuit BUFFa2 est configuré pour fournir sur sa sortie 410 une tension ayant une valeur identique à celle d'une tension qu'il reçoit sur son entrée 412, tout en assurant une isolation entre son entrée et sa sortie. Dit encore autrement, le circuit BUFFa2 est un circuit suiveur à gain unitaire.

L'entrée 412 du circuit BUFFa2 est connectée à un noeud intermédiaire du pont 400, par exemple au noeud 406. Dans le mode de réalisation de la figure 4, la sortie 410 du circuit BUFFa2 fournit la tension VrefL.

Le dispositif REFGEN comprend en outre un transistor MOS To2. Le drain du transistor To2 est connecté à la sortie du circuit BUFFa2. La source du transistor To2 est connectée au noeud 204 dans le mode de réalisation de la figure 4 où le circuit BUFFa2 est configuré pour fournir la tension VrefL. Dit autrement, la source du transistor To2 et la source du transistor To1 sont connectées à des noeuds respectifs différents parmi les noeuds 202 et 204. Dans le mode de réalisation de la figure 4, le transistor To2 est à canal N.

Le transistor To2 est configuré pour être à l'état passant lorsque le transistor T8 est à l'état bloqué, et pour être à l'état bloqué lorsque le transistor T8 est à l'état passant.

Plus particulièrement, dans le mode de réalisation de la figure 4, le transistor To2 est configuré pour que son état passant ou bloqué soit déterminé par une valeur de tension V2 sur un noeud du pont diviseur 208, par exemple sur le noeud 210 du pont diviseur 300, et le transistor To1 est configuré pour que son état passant ou bloqué soit déterminé par une valeur de tension V1 sur un noeud du pont diviseur 400, par exemple sur le noeud 402 du pont 400. Le transistor To1 a sa grille couplée, de préférence connectée, au noeud 402, le transistor To2 ayant sa grille connectée, de préférence connectée, au noeud 210.

Dans une variante de réalisation (non illustrée) le dispositif REFGEN comprend un transistor MOS et un élément résistif en série entre les noeuds 202 et 204, identiques au transistor T5 et à l'élément R4 de la figure 2, et connectés entre eux, au pont 208 et au transistor To1 de la même façon que le transistor T5 et l'élément R4 en figure 2. Le transistor To1 n'est alors pas commandé par la tension V1 du pont 400. Par rapport au mode de réalisation illustré en figure 4, cette variante est plus encombrante.

Dans une autre variante de réalisation, pouvant être combinée avec la variante de réalisation ci-dessus, le dispositif REFGEN comprend un transistor MOS et un élément résistif en série entre les noeuds 202 et 204, identiques au transistor T5 et à l'élément R4 de la figure 3, et connectés entre eux, au pont 208 et au transistor To1 de la même façon que le transistor T5 et l'élément R4 en figure 3. Le transistor To2 n'est alors pas commandé par la tension V2 du pont 208. Par rapport au mode de réalisation illustré en figure 4, cette variante est plus encombrante.

Dans le mode de réalisation de la figure 4, le dispositif REFGEN comprend le circuit 222 de la figure 2.

Dans une variante de réalisation, le circuit 222 est omis.

Le fonctionnement du dispositif REFGEN de la figure 4 est à la portée de la personne du métier à partir de la description fonctionnelle faite précédemment des dispositifs REFGEN des figures 2 et 3.

Le dispositif REFGEN décrit en relation avec la figure 3 présente l'avantage de pouvoir être mis en oeuvre avec des transistors MOS similaires à ceux du dispositif IP, c'est à dire des transistors MOS ayant une tenue en tension Vmax

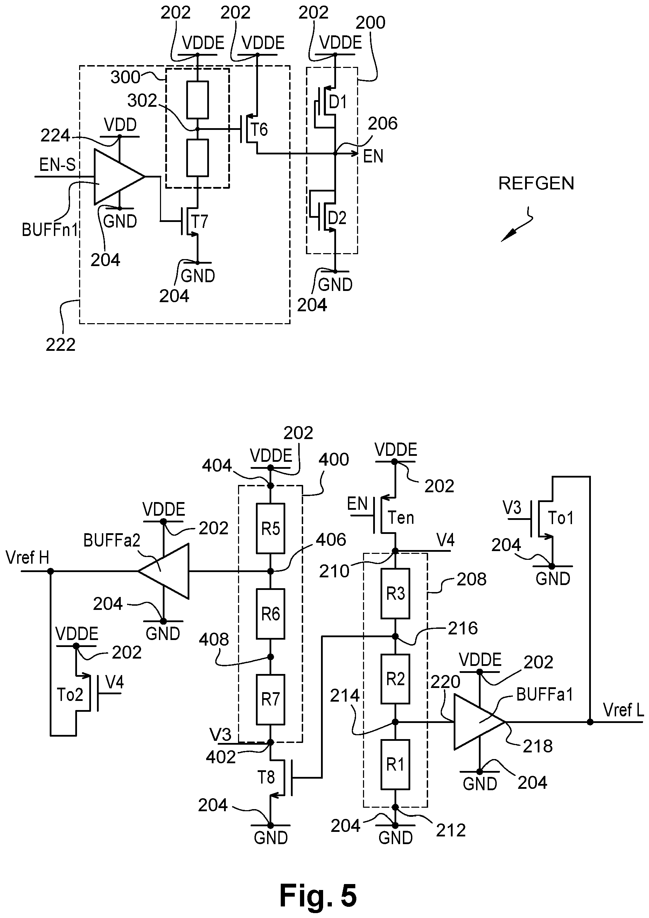

La figure 5 représente, sous la forme d'un circuit, une variante de réalisation du circuit REFGEN de la figure 3. Par rapport au circuit REFGEN de la figure 3 qui est configuré pour fournir la tension VrefL, le circuit REFGEN de la figure 5 est configuré pour générer la tension VrefL et la tension VrefH.

Le dispositif REFGEN de la figure 5 comprend de nombreux éléments en commun avec celui de la figure 3, et seules les différences entre ces deux dispositifs sont ici mises en exergue. En particulier, sauf indication contraire, tous ce qui a été indiqué pour le dispositif REFGEN décrit en relation avec la figure 3 s'applique au dispositif REFGEN de la figure 5. En outre, comme le dispositif REFGEN de la figure 5 comprend des éléments décrits en relation avec le dispositif REFGEN de la figure 4. Pour ces éléments, seules les différences entre la figure 4 et la figure 5 sont mises en exergue.

Par rapport au dispositif REFGEN de la figure 3, le dispositif REFGEN de la figure 5 comprend en outre, comme le dispositif REFGEN de la figure 4, le pont diviseur de tension résistif 400 et un transistor MOS T8 en série entre les noeuds 202 et 204.

La source du transistor T8 est connectée à celui des noeuds 202 et 204 auquel n'est pas connectée la source du transistor Ten, c'est-à-dire au noeud 204 dans le mode de réalisation de la figure 5. Dans le mode de réalisation de la figure 5, le transistor T8 est à canal N.

Le transistor T8 est configuré pour être passant, respectivement bloqué, lorsque le transistor Ten est passant, respectivement bloqué. Dans le mode de réalisation de la figure 4, le transistor T8 a sa grille connectée à un noeud intermédiaire du pont 208, par exemple au noeud 216.

Le pont diviseur 400 a son extrémité 404 connectée au noeud 202 dans le mode de réalisation de la figure 4.

Par rapport au dispositif REFGEN de la figure 3, le dispositif REFGEN de la figure 5 comprend, comme le circuit REFGEN de la figure 4, le circuit tampon BUFFa2. L'entrée 412 du circuit BUFFa2 est connectée à un noeud intermédiaire du pont 400, par exemple au noeud 406. Dans le mode de réalisation de la figure 5, la sortie 410 du circuit BUFFa2 fournit la tension VrefH.

Le dispositif REFGEN de la figure 5 comprend en outre, comme le dispositif REFGEN de la figure 4, un transistor MOS To2. La source du transistor To2 est connectée au noeud 202 dans le mode de réalisation de la figure 5 où le circuit BUFFa2 est configuré pour fournir la tension VrefH. Dit autrement, la source du transistor To2 et la source du transistor To1 sont connectées à des noeuds respectifs différents parmi les noeuds 202 et 204. Dans le mode de réalisation de la figure 5, le transistor To2 est à canal P.

Plus particulièrement, dans le mode de réalisation de la figure 5, le transistor To2 est configuré pour que son état passant ou bloqué soit déterminé par une valeur de tension V4 sur un noeud du pont diviseur 208, par exemple sur le noeud 210 du pont diviseur 300, et le transistor To1 est configuré pour que son état passant ou bloqué soit déterminé par une valeur de tension V3 sur un noeud du pont diviseur 400, par exemple sur le noeud 402 du pont 400. Le transistor To1 a sa grille couplée, de préférence connectée, au noeud 402, le transistor To2 ayant sa grille connectée, de préférence connectée, au noeud 210.

Dans une variante de réalisation (non illustrée) le dispositif REFGEN comprend un transistor MOS et un élément résistif en série entre les noeuds 202 et 204, identiques au transistor T5 et à l'élément R4 de la figure 3, et connectés entre eux, au pont 208 et au transistor To1 de la même façon que le transistor T5 et l'élément R4 en figure 3. Le transistor To1 n'est alors pas commandé par la tension V3 du pont 400. Par rapport au mode de réalisation illustré en figure 5, cette variante est plus encombrante.

Dans une autre variante de réalisation, pouvant être combinée avec la variante de réalisation ci-dessus, le dispositif REFGEN comprend un transistor MOS et un élément résistif en série entre les noeuds 202 et 204, identiques au transistor T5 et à l'élément R4 de la figure 2, et connectés entre eux, au pont 208 et au transistor To1 de la même façon que le transistor T5 et l'élément R4 en figure 2. Le transistor To2 n'est alors pas commandé par la tension V4 du pont 208. Par rapport au mode de réalisation illustré en figure 4, cette variante est plus encombrante.

Dans le mode de réalisation de la figure 5, le dispositif REFGEN comprend le circuit 222 de la figure 3.

Dans une variante de réalisation, le circuit 222 est omis.

Le fonctionnement du dispositif REFGEN de la figure 5 est à la portée de la personne du métier à partir de la description fonctionnelle faite précédemment des dispositifs REFGEN des figures 2 et 3.

Le dispositif REFGEN décrit en relation avec la figure 3 présente l'avantage de pouvoir être mis en oeuvre avec des transistors MOS similaires à ceux du dispositif IP, c'est à dire des transistors MOS ayant une tenue en tension Vmax, sauf en ce qui concerne le transistor T7 qui est dimensionner pour pouvoir tenir la tension VDDE sur son drain.

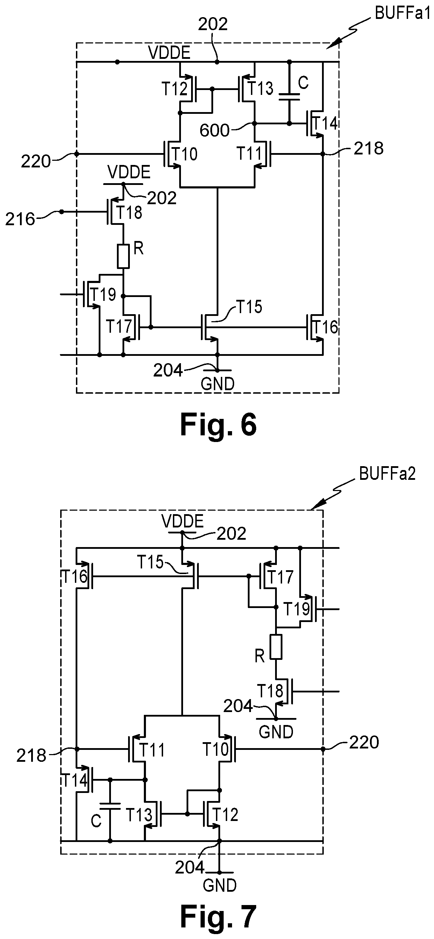

La figure 6 représente, sous la forme d'un circuit, un exemple de mode de réalisation d'un circuit tampon analogique configuré pour fournir la tension VrefH. Dans cet exemple, le circuit tampon décrit est le circuit BUFFa1 mis en oeuvre dans le circuit REFGEN de la figure 4.

Le circuit BUFFa1 comprend une paire différentielle comprenant deux transistors MOS T10 et T11. Comme le circuit BUFFa1 fournit la tension VrefH, les transistors T10 et T11 sont de préférence à canal N.

Le transistor T10 a sa grille connectée à l'entrée 220 du circuit BUFFa1, et reçoit donc, dans cet exemple, la tension présente sur le noeud 214 du pont 208 (figure 4). Le transistor T11 a sa grille connectée à la sortie 218 du circuit BUFFa1, et reçoit donc la tension VrefH.

Le circuit BUFFa1 comprend en outre deux transistors MOS T12 et T13 montés en miroir de courant l'un de l'autre, et configuré pour polariser les transistors respectifs T10 et T11 de la paire différentielle. Comme le circuit BUFFa1 fournit la tension VrefH, les transistors T12 et T13 sont de préférence à canal P. Par exemple, les transistors T12 et T13 ont leurs sources connectées au noeud 202 et leurs grilles connectées l'une à l'autre, la grille du transistor T12 étant en outre connectée au drain de ce transistor T12. Par exemple, le drain du transistor T12, respectivement T13, est connecté au drain du transistor T10, respectivement T11.

Le circuit BUFFa1 comprend en outre un transistor MOS T14 ayant sa grille connectée à un noeud 600 de connexion du transistor T13 au transistor T11, et sa source connectée à la sortie 218 du circuit. Comme le circuit BUFFa1 fournit la tension VrefH, le transistor T14 est, de préférence, à canal N et a son drain connecté au noeud 202.

De préférence, un élément capacitif C est connecté entre la grille et la source du transistor T14 pour améliorer la stabilité du circuit BUFFa1.

Le circuit BUFFa1 comprend en outre un transistor MOS T15 couplant la paire différentielle (transistors T10 et T11) à celui des noeuds 202 et 204 auquel ne sont pas connectés les transistors T12 et T13, et un transistor MOS T16 couplant la sortie 218 à celui des noeuds 202 et 204 auquel n'est pas connecté le transistor T14. Dans l'exemple de la figure 6, comme les transistors T12 et T13 sont connectés au noeud 202, le transistor T15 couple donc la paire différentielle au noeud 204, et, en outre, comme le transistor T14 est connecté au noeud 202, le transistor T16 couple donc la sortie 218 au noeud 204. Dans cet exemple, les transistors T15 et T16 sont donc à canal N. Par exemple, les transistors T15 et T16 ont leurs sources connectées au noeud 204, le transistor T15 a son drain couplé, de préférence connecté, aux sources des transistors T10 et T11 de la paire différentielle, et le transistor T16 a son drain couplé, de préférence connecté, à la sortie 218.

Le circuit BUFFa1 comprend en outre un transistor MOS T17 à canal du même type que celui des canaux des transistors T15 et T16, à savoir à canal N dans cet exemple. Ce transistor T17 a sa source connectée au même noeud, 204 dans cet exemple, que le noeud auquel sont connectées les sources des transistors T15 et T16. Les transistors T15 et T16 sont montés en miroir de courant avec le transistor T17. Par exemple, les grilles des transistors T15 et T16 sont connectées chacune à la grille du transistor T17, la grille du transistor T17 étant en outre connectée au drain du transistor T17.

Selon un mode de réalisation, le transistor T17 est avantageusement polarisé à partir d'un noeud intermédiaire du pont diviseur résistif auquel est connecté le circuit BUFFa1, à savoir à partir d'un noeud intermédiaire du pont 208 dans cet exemple, par exemple à partir du noeud 216 du pont 208 (figure 4).

Par exemple, le circuit BUFFa1 comprend un transistor MOS T18 à canal du type opposé à celui du canal du transistor T17, et ayant sa source connectée à celui des noeuds 202 et 204 auquel n'est pas connecté le transistor T17. Ainsi, dans cet exemple, le transistor T18 est à canal P et a sa source connectée au noeud 202. De plus, la grille du transistor T18 est connectée au noeud intermédiaire 216 du pont 208 à partir duquel est polarisé le transistor T17. Une résistance R couple les drains des transistors T17 et T18 entre eux.

Dans une variante de réalisation, le transistor T17 peut être polarisé autrement qu'à partir d'un noeud du pont diviseur résistif auquel est connecté l'entrée 220 du circuit BUFFa1.

Selon un mode de réalisation, pour limiter la consommation du circuit BUFFa1 lorsque le transistor Ten est à l'état bloqué (figure 4), le circuit BUFFa1 comprend un transistor MOS T19 à canal du même type que celui du transistor T17, à savoir à canal N dans cet exemple. Le transistor T19 est configuré pour court-circuiter le transistor T17 lorsque le transistor Ten (figure 4) est bloqué. Par exemple, le transistor T19 a sa source, respectivement son drain, connectée à la source, respectivement au drain, du transistor T17. A titre d'exemple, pour que le transistor T19 soit passant lorsque le transistor Ten est bloqué, la grille du transistor T19 est couplée, de préférence connectée, au drain du transistor qui est en série avec le pont diviseur résistif auquel est connectée l'entrée 220 du circuit BUFFa1, c'est à dire au drain du transistor Ten dans cet exemple.

Bien que l'on ait décrit ci-dessus un exemple de mode de réalisation du circuit BUFFa1 du dispositif REFGEN de la figure 4, le circuit BUFFa2 de la figure 5 peut être mis en oeuvre par le circuit décrit en relation avec la figure 6. A titre d'exemple, dans ce cas, la grille du transistor T10 est connectée au noeud 406 du pont 400, la grille du transistor T18 est connectée à un noeud du pont 400, par exemple au noeud 408, et la grille du transistor T19 est connectée au drain du transistor T8.

La figure 7 représente, sous la forme d'un circuit, un exemple d'un mode de réalisation d'un circuit tampon analogique configuré pour fournir la tension VrefL. Dans cet exemple, le circuit tampon décrit est le circuit BUFFa2 mis en oeuvre dans le circuit REFGEN de la figure 4.

Le circuit BUFFa2 de la figure 7 est similaire au circuit BUFFa1 de la figure 6 et comprend de nombreux éléments en commun avec ce dernier, seules les différences entre ces deux dispositifs étant ici mises en exergue.

En particulier, comme le circuit BUFFa2 fournit la tension VrefL, les transistors T10 et T11 du circuit BUFFa2 sont de préférence à canal P.

Le transistor T10 a ici sa grille connectée à l'entrée 220 du circuit BUFFa2, et reçoit donc, dans cet exemple, la tension présente sur le noeud 406 du pont 400 (figure 4). En outre, le transistor T11 a ici sa grille connectée à la sortie 218 du circuit BUFFa2, et reçoit donc la tension VrefL.

Comme le circuit BUFFa2 fournit la tension VrefL, les transistors T12 et T13 montés en miroir de courant l'un de l'autre pour polariser les transistors respectifs T10 et T11 de la paire différentielle sont de préférence à canal N. Par exemple, les transistors T12 et T13 ont ici leurs sources connectées au noeud 204 et leurs grilles connectées l'une à l'autre, la grille du transistor T12 étant en outre connectée au drain de ce transistor T12. Par exemple, le drain du transistor T12, respectivement T13, est connecté au drain du transistor T10, respectivement T11.

Comme le circuit BUFFa2 fournit la tension VrefL, le transistor T14 ayant sa grille connectée au noeud 600 et sa source connectée à la sortie 218 du circuit BUFFa2 est, de préférence, à canal P et a son drain connecté au noeud 202.

De préférence, le circuit BUFFa2 comprend l'élément capacitif C connecté entre la grille et la source du transistor T14 pour améliorer sa stabilité.

Dans ce mode de réalisation, les transistors T12 et T13 étant connectées au noeud 204, les transistors T15 et T16 sont connectés au noeud 202. Le transistor T15 couple donc la paire différentielle au noeud 202, et, en outre, le transistor T16 couple donc la sortie 218 au noeud 202. Dans cet exemple, les transistors T15 et T16 sont donc à canal P. Par exemple, les transistors T15 et T16 ont leurs sources connectées au noeud 202, le transistor T15 a son drain couplé, de préférence connecté, aux sources des transistors T10 et T11, et le transistor T16 a son drain couplé, de préférence connecté, à la sortie 218.

Le transistor T17 à canal du même type que celui des canaux des transistors T15 et T16 est donc à canal P dans le circuit BUFFa2, et a sa source connectée au même noeud, 202 dans cet exemple, que le noeud auquel sont connectées les sources des transistors T15 et T16. Les transistors T15 et T16 sont montés en miroir de courant avec le transistor T17.

Selon un mode de réalisation, le transistor T17 est avantageusement polarisé à partir d'un noeud intermédiaire du pont diviseur résistif auquel est connecté le circuit BUFFa2, à savoir à partir d'un noeud intermédiaire du pont 400 dans cet exemple, par exemple à partir du noeud 406 du pont 400 (figure 4).

Par exemple, le circuit BUFFa2 comprend le transistor MOS T18 à canal du type opposé à celui du canal du transistor T17, et ayant sa source connectée à celui des noeuds 202 et 204 auquel n'est pas connecté le transistor T17. Ainsi, dans cet exemple, le transistor T18 est à canal N et a sa source connectée au noeud 204. De plus, la grille du transistor T18 est connectée au noeud intermédiaire 406 du pont 400 à partir duquel est polarisé le transistor T17. La résistance R couple les drains des transistors T17 et T18 entre eux.

Dans une variante de réalisation, le transistor T17 peut être polarisé autrement qu'à partir d'un noeud du pont diviseur résistif auquel est connecté l'entrée 220 du circuit BUFFa2.

Selon un mode de réalisation, pour limiter la consommation du circuit BUFFa2 lorsque le transistor Ten est à l'état bloqué (figure 4), le circuit BUFFa2 comprend un transistor MOS T19 à canal du même type que celui du transistor T17, à savoir à canal P dans cet exemple. Le transistor T19 est configuré pour court-circuiter le transistor T17 lorsque le transistor Ten (figure 4) est bloqué. Par exemple, le transistor T19 a sa source, respectivement son drain, connectée à la source, respectivement au drain, du transistor T17. A titre d'exemple, pour que le transistor T19 soit passant lorsque le transistor Ten est bloqué, la grille du transistor T19 est couplée, de préférence connectée, au drain du transistor qui est en série avec le pont diviseur résistif auquel est connectée l'entrée 220 du circuit BUFFa2, c'est à dire au drain du transistor T8 dans cet exemple.

Bien que l'on ait décrit ci-dessus un exemple de mode de réalisation du circuit BUFFa2 du dispositif REFGEN de la figure 4, le circuit BUFFa1 de la figure 5 peut être mis en oeuvre par le circuit décrit en relation avec la figure 7. A titre d'exemple, dans ce cas, la grille du transistor T10 du circuit de la figure 7 est connectée au noeud 214 du pont 208, la grille du transistor T18 est connectée à un noeud du pont 208, par exemple au noeud 216, et la grille du transistor T19 est connectée au drain du transistor Ten.

Dans les modes de réalisation et variantes décrits précédemment en relation avec les figures 1 à 7, chacune des tensions VrefH et VrefL est générée à partir de la tension VDDE. Ainsi, chacune des tensions VrefH et VrefL suit les variations de la tension VDDE, et, en particulier, les surtensions ou les sous-tensions de la tension VDDE. Cela permet de garder les tensions aux bornes des transistors cascodes T2 et T3 des structures 100 et 102 à des valeurs inférieures à la limite de tenue en tension Vmax de ces transistors. En outre, comme chacune des tensions VrefH et VrefL suit les variations de la tension VDDE et n'est pas générée à partir de la tension VDD, il n'y a plus de contrainte sur l'ordre dans lequel doivent être fournies les tensions d'alimentation VDDE et VDD.

Dans les modes de réalisation et variantes décrits précédemment en relation avec les figures 1 à 7, lorsque le transistor Ten est passant, chacune des tensions VrefH et VrefL est générée à partir de la tension VDDE par un pont diviseur de tension résistif 208 ou 400 correspondant. Ainsi, la dépendance de la valeur courante de chacune des tensions VrefL et VrefH à la température est réduite ou supprimée. En outre, le rapport entre la valeur courante de la tension VrefH, respectivement VrefL, et celle de la tension VDDE peut être aisément choisit en adaptant les valeurs d'un ou plusieurs des éléments résistifs du pont 208 ou 400 correspondant.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Dispositif (REFGEN) de génération de tension de référence (VrefH, VrefL) comprenant :
un premier pont diviseur de tension (200) connecté entre un premier noeud d'alimentation (202) configuré pour recevoir une première tension d'alimentation (VDDE) et un deuxième noeud d'alimentation (204) configuré pour recevoir un potentiel de référence (GND) ;
un premier transistor MOS (Ten) et un deuxième pont diviseur de tension résistif (208) connectés en série entre les premier et deuxième noeuds d'alimentation (202, 204), le premier transistor ayant sa grille connectée à un noeud intermédiaire (206) du premier pont et sa source connectée à l'un des premier et deuxième noeuds d'alimentation ;
un premier circuit tampon (BUFFa1) configuré pour être alimenté par la première tension (VDDE) et comprenant une entrée (220) connectée à un premier noeud intermédiaire (214) du deuxième pont et une sortie (218) configurée pour fournir une première tension de référence (VrefH, VrefL) ; et
un deuxième transistor MOS (To1) ayant son drain connecté à la sortie du premier circuit tampon et sa source connectée à l'un des premier et deuxième noeuds d'alimentation (202, 204),
dans lequel le premier pont (200) est configuré pour que le premier transistor (Ten) soit bloqué lorsque la première tension (VDDE) est à une valeur inférieure à un premier seuil lui-même inférieur à une limite de tenue en tension des transistors, et
dans lequel le deuxième transistor (To1) est configuré pour être à l'état passant si le premier transistor (Ten) est à l'état bloqué et inversement.

2. Dispositif selon la revendication 1, dans lequel :
le premier transistor (Ten) est à canal N et a sa source connectée au deuxième noeud d'alimentation (204) ;
le dispositif (REFGEN) comprend en outre un troisième transistor MOS (T5 ; T8) en série avec un premier élément résistif (R4 ; R6, R7, R8) entre les premier et deuxième noeuds d'alimentation, le troisième transistor étant à canal P et ayant sa source connectée au premier noeud d'alimentation (202) et sa grille connectée à un deuxième noeud intermédiaire (216) du deuxième pont (208) ; et
le deuxième transistor (To1) est à canal P et a sa grille connectée au drain du troisième transistor.

3. Dispositif selon la revendication 2, dans lequel le dispositif (REFGEN) comprend en outre :
un deuxième circuit tampon (BUFFn1) configuré pour être alimenté par une deuxième tension d'alimentation (VDD) ayant une valeur nominale plus faible que celle de la premier tension d'alimentation (VDDE) ; et
un transistor MOS à canal N (T6) ayant sa source connectée au deuxième noeud d'alimentation (204), son drain connecté au noeud intermédiaire (206) du premier pont (200) et sa grille connectée à la sortie du deuxième circuit tampon,
dans lequel le deuxième circuit tampon est destiné à recevoir un signal binaire (EN-S) à un niveau bas correspondant à une tension nulle si une valeur courante de la première tension (VDDE) est supérieure à la limite de tenue en tension des transistors, et à un niveau bas ou haut déterminé par une commande (cmd) sinon, le niveau haut dudit signal correspondant à la deuxième tension d'alimentation (VDD).

4. Dispositif selon la revendication 1, dans lequel :
le premier transistor (Ten) est à canal P et a sa source connectée au premier noeud d'alimentation (202) ;
le dispositif comprend en outre un troisième transistor MOS (T5 ; T8) en série avec un premier élément résistif (R4 ; R6, R7, R8) entre les premier et deuxième noeuds d'alimentation, le troisième transistor étant à canal N et ayant sa source connectée au deuxième noeud d'alimentation (204) et sa grille connectée à un deuxième noeud intermédiaire (216) du deuxième pont (208) ; et
le deuxième transistor (To1) est à canal N et a sa grille connectée au drain du troisième transistor.

5. Dispositif selon la revendication 4, dans lequel le dispositif (REFGEN) comprend en outre :
un deuxième circuit tampon (BUFFn1) configuré pour être alimenté par une deuxième tension d'alimentation (VDD) ayant une valeur nominale plus faible que celle de la premier tension d'alimentation (VDDE) ;
un troisième pont diviseur de tension (300) et un transistor MOS à canal N (T7) connectés en série entre les premier et deuxième noeuds d'alimentation (202, 204), le transistor sa source connectée au deuxième noeud d'alimentation (204), son drain connecté au troisième pont et sa grille connectée à la sortie du deuxième circuit tampon (BUFFn1) ; et
un transistor MOS à canal P (T6) ayant sa source connectée au premier noeud d'alimentation (202), sa grille connectée au noeud intermédiaire (302) du troisième pont (300) et son drain connecté au noeud intermédiaire (206) du premier pont (200),
dans lequel le deuxième circuit tampon (BUFFn1) est destiné recevoir un signal binaire (EN-S) à un niveau bas correspondant à une tension nulle si une valeur courante de la première tension (VDDE) est supérieure à la limite de tenue en tension des transistors, et à un niveau bas ou haut déterminé par une commande sinon, le niveau haut dudit signal correspondant à la deuxième tension d'alimentation.

6. Dispositif selon la revendication 1, dans lequel le dispositif (REFGEN) comprend en outre :
un troisième transistor MOS (T8) et un troisième pont diviseur de tension résistif (400) connectés en série entre les premier et deuxième noeuds d'alimentation (202, 204), les sources des premier et troisième transistors (Ten, T8) étant connectées à des noeuds respectifs différents parmi les premier et deuxième noeuds d'alimentation (202, 204) ;
un deuxième circuit tampon (BUFFa2) configuré pour être alimenté par la première tension (VDDE) et comprenant une entrée (220) connectée à un premier noeud intermédiaire (406) du troisième pont (400) et une sortie (218) configurée pour fournir une deuxième tension de référence (VrefH ; VrefL) ; et
un quatrième transistor MOS (To2) ayant son drain connectée à la sortie du deuxième circuit tampon (BUFFa2), les sources des deuxième et quatrième transistors (To1, To2) étant connectées à des noeuds respectifs différents parmi les premier et deuxième noeuds d'alimentation (202, 204) ;
dans lequel le troisième transistor (T8) est configuré pour être à l'état bloqué, respectivement passant, quand le premier transistor (Ten) est à l'état bloqué, respectivement passant, et
dans lequel le quatrième transistor (To2) est configuré pour être à l'état passant si le troisième transistor (T8) est à l'état bloqué et inversement.

7. Dispositif selon la revendication 6, dans lequel :
le premier transistor (Ten) est à canal N et a sa source connectée au deuxième noeud d'alimentation (204) ;
le troisième transistor (T8) est à canal P et a sa grille connectée à un deuxième noeud intermédiaire (216) du deuxième pont (208) ;
le deuxième transistor (To1) est à canal P et a sa grille couplée, de préférence connectée, au drain du troisième transistor (T8) et sa source connectée au premier noeud d'alimentation (202) ; et
le quatrième transistor (To2) est à canal N et a sa grille couplée, de préférence connectée, au drain du premier transistor (Ten).

8. Dispositif selon la revendication 7, dans lequel le dispositif (REFGEN) comprend en outre :
un troisième circuit tampon (BUFFn1) configuré pour être alimenté par une deuxième tension d'alimentation (VDD) ayant une valeur nominale plus faible que celle de la première tension d'alimentation (VDDE) ; et
un transistor MOS à canal N (T6) ayant sa source connectée au deuxième noeud d'alimentation (204), son drain connecté au noeud intermédiaire (206) du premier pont (200) et sa grille connectée à la sortie du troisième circuit tampon (BUFFn1),
dans lequel le troisième circuit tampon (BUFFn1) est destiné à recevoir un signal binaire (EN-S) à un niveau bas correspondant à une tension nulle si une valeur courante de la première tension (VDDE) est supérieure à la limite de tenue en tension des transistors, et à un niveau bas ou haut déterminé par une commande sinon, le niveau haut dudit signal correspondant à la deuxième tension d'alimentation (VDD).

9. Dispositif selon la revendication 6, dans lequel :
le premier transistor (Ten) est à canal P et a sa source connectée au premier noeud d'alimentation (202) ;
le troisième transistor (T8) est à canal N et a sa grille connectée à un deuxième noeud intermédiaire (216) du deuxième pont (208) ;
le deuxième transistor (To1) est à canal N et a sa grille couplée, de préférence connectée, au drain du troisième transistor (T8) et sa source connectée au deuxième noeud d'alimentation (204) ; et
le quatrième transistor est à canal P et a sa grille couplée, de préférence connectée, au drain du premier transistor (Ten).

10. Dispositif selon la revendication 9, dans lequel le dispositif comprend en outre :
un troisième circuit tampon (BUFFn1) configuré pour être alimenté par une deuxième tension d'alimentation (VDD) ayant une valeur nominale plus faible que celle de la premier tension d'alimentation (VDDE) ;
un quatrième pont diviseur de tension (300) et un transistor MOS à canal N (T7) connectés en série entre les premier et deuxième noeuds d'alimentation (202, 204), le transistor ayant sa source connectée au deuxième noeud d'alimentation (204), son drain connecté au quatrième pont (300) et sa grille connectée à la sortie du troisième circuit tampon (BUFFn1) ; et
un transistor MOS à canal P (T6) ayant sa source connectée au premier noeud d'alimentation (202), sa grille connectée au noeud intermédiaire (302) du quatrième pont (300) et son drain connecté au noeud intermédiaire (206) du premier pont (200),
dans lequel le troisième circuit tampon (BUFFn1) est configuré pour recevoir un signal binaire (EN-S) à un niveau bas correspondant à une tension nulle si une valeur courante de la première tension (VDDE) est supérieure à la limite de tenue en tension des transistors, et à un niveau bas ou haut déterminé par une commande (cmd) sinon, le niveau haut dudit signal correspondant à la deuxième tension d'alimentation (VDD).

11. Système (1) comprenant un dispositif (REFGEN) selon l'une quelconque des revendications 3, 5, 8 et 10, et un circuit (108) configuré pour recevoir ladite commande (cmd), la première tension (VDDE) et la deuxième tension (VDD), et pour fournir ledit signal binaire (EN-S).
